Europäisches Patentamt

European Patent Office

Office européen des brevets

(11) Publication number: **0 156 487**
A1

## EUROPEAN PATENT APPLICATION

(21) Application number: 85301004.9

(22) Date of filing: 15.02.85

(51) Int. Cl.⁴: **H 03 F 3/45**

(30) Priority: 02.03.84 GB 8405596

(43) Date of publication of application:
02.10.85 Bulletin 85/40

(84) Designated Contracting States:
AT BE CH DE FR IT LI LU NL SE

(71) Applicant: STANDARD TELEPHONES AND CABLES
PUBLIC LIMITED COMPANY
190 Strand
London, WC2R 1DU(GB)

(72) Inventor: Neale, Michael William
7, Brook Hampton Street
Ickleton Cambridge(GB)

(74) Representative: Dennis, Mark Charles
STC Patent Department Edinburgh Way
Harlow Essex CM20 2SH(GB)

(54) Amplifier circuit for radio receiver.

(57) A limiting differential amplifier circuit comprises first and second controllable current sources ($I_1$, $I_2$) fed with the differential input signal ($V_m$) and a controllable differential load circuit ($I_{L1}$, $I_{L2}$) and a feedback element ($\beta$), the feedback element comprising transistors ($T_1$, $T_2$) sensing the common mode output voltage and a diode ($D_1$) for translating the current generated into a control voltage ($V_c$) to control the differential load circuit whereby to provide high-voltage gain in the differential signal mode and low common-mode gain.

EP 0 156 487 A1

## AMPLIFIER CIRCUITS FOR RADIO RECEIVERS

This invention relates to radio receivers particularly but not exclusively radio pagers and amplifier circuits for them.

Our British Patent 1517121 describes a radio pager for FSK signals and similar to the STC Model 5C pager. This pager is a tone-only receiver operating in the VHF high band (138-174 MHz). It uses a binary digital code format to the POCSAG standard, which provides the receiver with four addresses, each distinguished by a different alert tone pattern.

In order to make it possible to produce the complete radio receiver on a single chip, a direct conversion technique is employed in which the radio frequency signal is mixed with a local oscillator on the nominal channel frequency, resulting in a "Zero I.F.". Because the radio signal is frequency modulated there is in fact a beat frequency produced in the mixer, equal to the frequency deviation of the carrier. Conventional I.F. strips are replaced by audio frequency amplifiers with this technique, and adjacent channel selectivity is provided by low pass filters.

To make it possible to recover frequency modulation, the radio frequency signal is fed to two paths with a 90 degree phase difference between them. Each path has its own mixer, fed from the same local oscillator and its own low pass filter and limiting amplifier. The phase relationship of the two baseband signals will vary according to whether the radio carrier frequency is above or below the local oscillator frequency. The two baseband signals can therefore be combined to recover the modulating signal and this is done in a D-type clocked flip-flop to the D-input of which is applied the output of one of the limiting amplifier stages whilst the output of the other limiting amplifier stage is applied to the clock input of the flip-flop.

It is an object of the present invention to provide an improved radio receiver in which the differential amplifier has a high voltage in the differential signal mode gain yet very low common mode gain enabling a stable operating point.

According to the present invention there is provided a signal processing circuit comprising a high gain differential amplifier, the amplifier comprising first and second controllable current sources fed with the differential input signal and a controllable differential load circuit, characterised in that the differential current ($I_1$, $I_2$) produced is applied across the differential load circuit ($I_{L1}$, $I_{L2}$) and a feedback element , the feedback element comprising transistors ($T_1$, $T_2$) sensing the common mode output voltage and means ($D_1$) for translating the current so generated into a control voltage ($V_c$) to control the differential load circuit ($I_{L1}$, $I_{L2}$) whereby to provide high voltage gain in the differential signal mode and low common-mode gain.

In order that the invention can be clearly understood, reference will now be made to the accompanying drawings in which:-

Fig. 1 is a block circuit diagram of a radio receiver embodying the invention;

Fig. 2 shows a theoretical model of a high gain amplifier for explaining the present invention;

Fig. 3 shows a further explanatory model;

Figs. 4 to 9 show various embodiments of the present invention each suitable for use in Fig. 1.

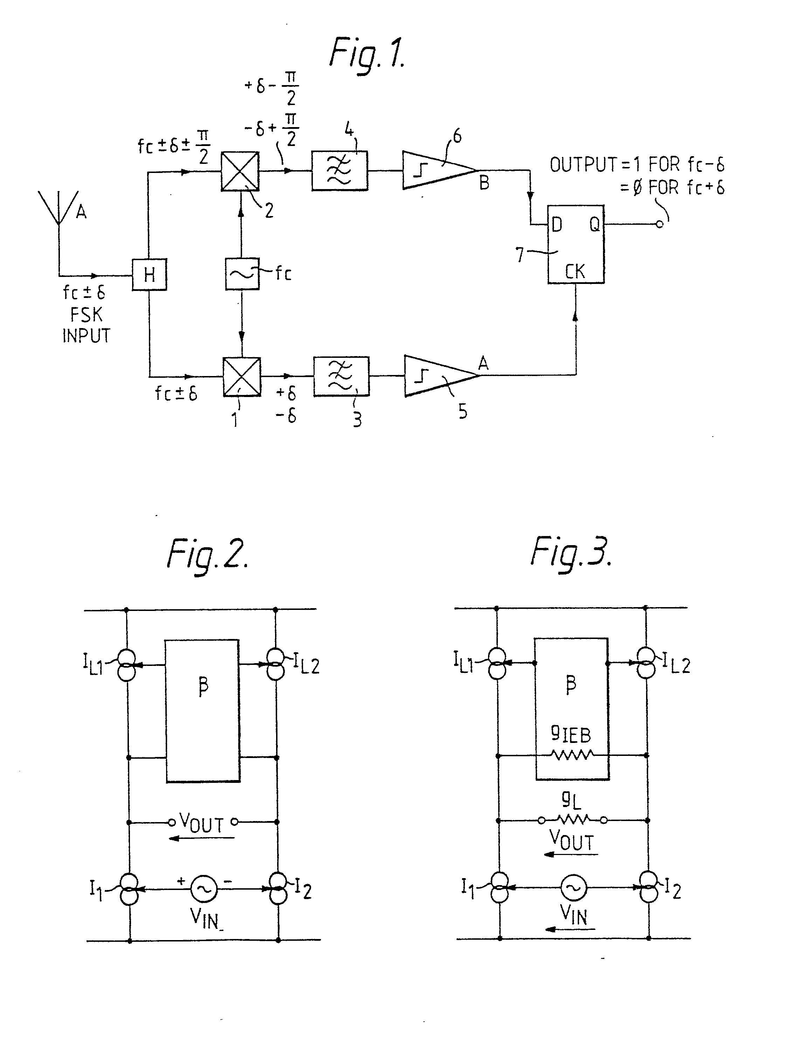

Referring to Fig. 1 the input from the aerial A is fed via an r.f. amplifier (not shown) to a hybrid transformer H which with associated components (not shown) provides the two signals in quadrature at the mixers 1 and 2.

Mixers 1 and 2 have a local oscillator $f_c$ providing inputs to derive the baseband signals which are fed to respective bandpass filters 3 and 4.

The outputs from the filters 3 and 4 feed the low gain high frequency limiter amplifiers 5 and 6 whose signals are combined in the D-type flip-flop 7 and thence fed to the decoder logic circuitry.

The low gain high frequency limiter amplifiers 5 and 6 will now be described in detail. The amplifier cicuit achieves very high voltage gains in a differential signal mode but has very low common-mode gain, thus maintaining a stable operating point. The common-mode operating point is stabilised by the use of a negative feedback control loop.

Fig. 2 shows the basic circuit configuration.

Controllable current sources $I_1$ and $I_2$ are fed with a differential input signal $V_{in}$. As such, they form the canonic differential amplifier configuration. The differential current so produced $g_m V_{in}$ (where $g_m$ is the transconductance of $I_1$ and $I_2 (gm_{I_1} = gm_{I_2})$ is applied across the differential load circuit $I_{L1}$, $I_{L2}$ and the feedback element $\beta$. By partition the differential output voltage so produced will be

$$V_{OUT} = \frac{-g_m}{g_{OE_o}} V_{in}$$

Where $g_{OE_o}$ is the output conductance of the current sources $I_{L1}$ and $I_{L2}$ in parallel with the output conductance of the current sources $I_1$ and $I_2$ assuming:

$$g_{OE_{I_1}} = g_{OE_{I_2}}$$

a necessary condition for the correct operation of the differential source and

$$g_{OE_{L1}} = g_{OE_{L2}}$$

so that

$$g_{OE_0} = g_{OE_I} + g_{OE_L}$$

In practice, voltage gains of over 1000 are easily achieved and because of this the common mode d.c. voltage at the output nodes can be virtually uncontrollable leading to voltage saturation of one or other of the current sources and thus highly non-linear operation.   Feedback loop $\beta$ monitors the common-mode output voltage and adjusts the currents $I_{L1}$ and $I_{L2}$, which are of equal value, so as to maintain the required common-mode output voltage, irrespective of $I_1$ and $I_2$, thus maintaining linear operation of the amplifier circuit.

Practical realisation

In practice, controllable current sources $I_1$, $I_2$, $I_{L1}$ and $I_{L2}$ and the feedback element $\beta$ can be realised with bipolar transistors, unipolar transistors, field effect transistors, thermionic-valves, etc. Although the following embodiments show bipolar transistors, substitution of the other types of device mentioned above will be tacitly assumed.

a) Gain limitation

In practice, the voltage gain is not only limited by the output conductance of the current sources, but also the input conductance of the feedback network and load (see Fig. 3).

The gain of this more realistic configuration is thus

$$\frac{V_o}{V_m} = \frac{g_m}{g_{OE_I} + g_{OE_L} + g_{OE_\beta} + g_L}$$

Very high voltage gains can still be achieved even with these practical limitations.

b) The Feedback Network

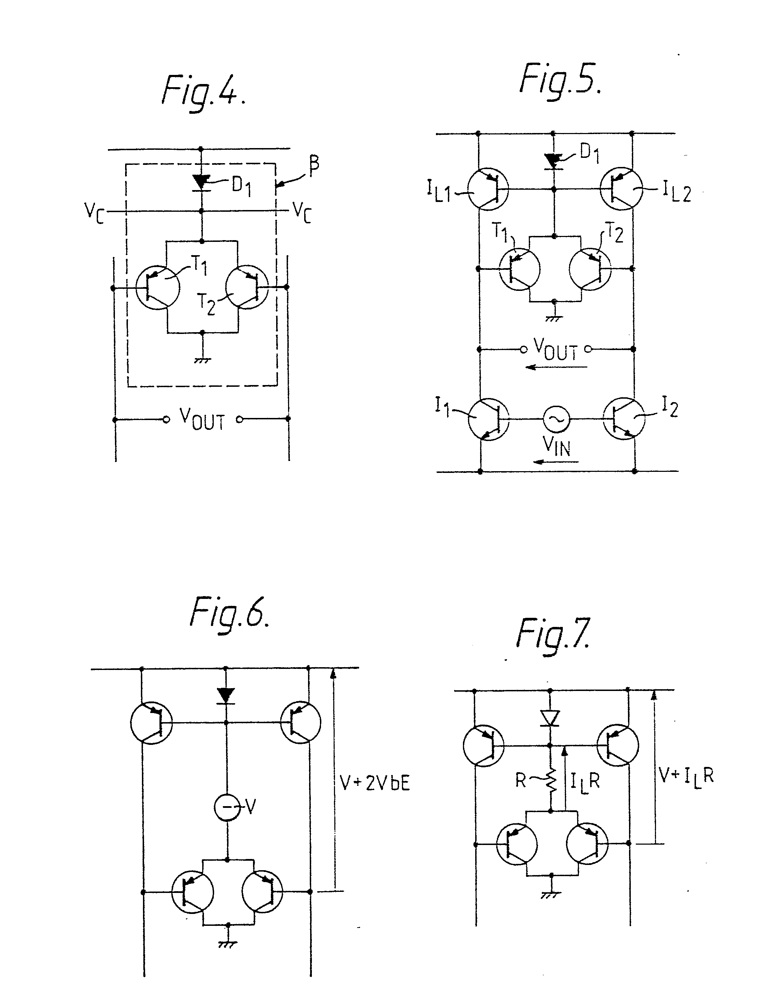

An importance aspect of the present invention is the feedback network $\beta$. Fig. 4 shows an example realised in bipolar transistors.

Transistors $T_1$ and $T_2$ sense the common-mode output voltage and generate a current through $D_1$ proportional to this voltage. $D_1$ translates this current into a control voltage to drive the current source loads. Fig. 5 shows the complete realisation.

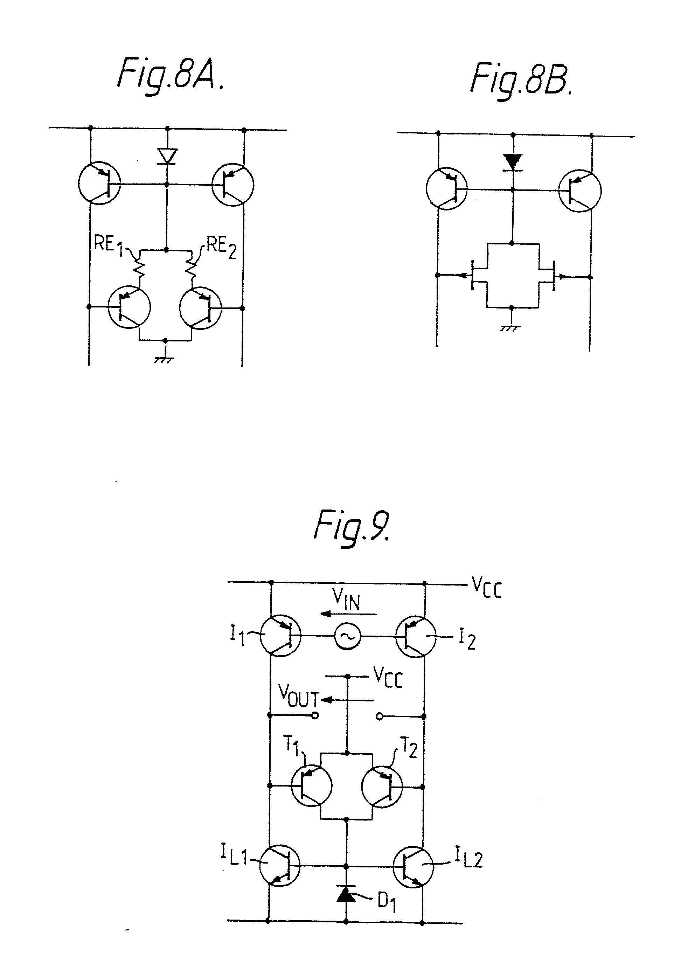

Any desired output common-mode voltage can be realised with the inclusion of a voltage source V in the feedback network as shown in Fig. 6. The voltage source V can be formed from forward buried diodes, Zener/avalanche diodes, or even resistors, (see Fig. 7). The use of a resistor does not degrade the feedback factor of the feedback element.

Greater amplifier linearity can be achieved by 'linearising' the loading effect of the feedback networks' input conductance. Figs. 8A and 8B show two methods of realising this. Fig. 8A shows the addition of two emitter resistors, $R_{E1}$ and $R_{E2}$, so as to allow differential output voltage swings of greater than 2 Vbe. Fig. 8B shows the use of field effect transistors which inherently have low input conductance variation with applied input voltage.

Finally, this circuit can obviously be realised in an inverted version of that already described as shown in Fig. 9.

All of the circuits described above are realisable in both discrete and monolithic form.

The receiver described in Fig. 1 has various uses, particularly for a radio pager as described, but also e.g. cordless telephones. A decoder circuit is necessary to utilise the data from the receiver circuit.

Preferably the amplifier circuits described are combined with the other elements of the radio receiver circuit shown in Fig. 1 and integrated into a single integrated circuit, except for the discrete components such as the hybrid transformer H, the crystal for the oscillator $f_c$ and filter elements for filters 3 and 4 which are too large to integrate.

CLAIMS:-

1. A signal processing circuit comprising a high gain differential amplifier, the amplifier comprising first and second controllable current sources fed with the differential input signal and a controllable differential load circuit, characterised in that the differential current ($I_1$, $I_2$) produced is applied across the differential load circuit ($I_{L1}$, $I_{L2}$) and a feedback element $\beta$, the feedback element comprising transistors ($T_1$, $T_2$) sensing the common mode output voltage and means ($D_1$) for translating the current so generated into a control voltage ($V_c$) to control the differential load circuit ($I_{L1}$, $I_{L2}$) whereby to provide high voltage gain in the differential signal mode and low common-mode gain.

2. A circuit as claimed in claim 1, characterised in that the means for translating the current comprises a unidirectional device ($D_1$) coupled in common to the corresponding electrodes of the sensing transistors ($T_1$, $T_1$), their other electrodes being held at a reference potential.

3. A circuit as claimed in claim 2, characterised in that the reference potential is ground.

4. A circuit as claimed in claim 1, claim 2 or claim 3, characterised in that the differential load circuit comprises transistors ($I_{L1}$, $I_{L2}$) operating as controllable current sources.

5. A circuit as claimed in claim 2, characterised in that the unidirectional device ($D_1$) comprises a forward buried diode, a zener diode, an avalanche diode, with or without a resistive element (R).

6. A circuit as claimed in any preceding claim, characterised in that the amplifier linearity is improved by linearising the loading effect of the input conductance of the feedback network (Fig. 8A, 8B).

7. A circuit as claimed in claim 6, comprising emitter resistors ($RE_1$, $RE_2$) connected to each sensing transistor.

- 8 -

0156487

8. A digital radio receiver comprising first and second signal channels in which the received modulated carrier signal is mixed with a reference signal to produce baseband signals from which the modulating information can be extracted, characterised in that each said channel incorporates a high differential gain, low common mode gain signal processing circuit as claimed in any preceding claim.

Fig.1.

Fig.2.

Fig.3.

0156487

## Fig.4.

## Fig.5.

## Fig.6.

## Fig.7.

## Fig.8A.

## Fig.8B.

$RE_1$   $RE_2$

## Fig.9.

$V_{CC}$

$V_{IN}$

$I_1$   $I_2$

$V_{CC}$

$V_{OUT}$

$T_1$   $T_2$

$I_{L1}$   $I_{L2}$

$D_1$

0156487

Application number

EP 85 30 1004

## EUROPEAN SEARCH REPORT

European Patent Office

### DOCUMENTS CONSIDERED TO BE RELEVANT

| Category | Citation of document with indication where appropriate, of relevant passages | Relevant to claim | CLASSIFICATION OF THE APPLICATION (Int Cl 4) |
|---|---|---|---|
| X | FR-A-2 277 461 (R.C.A.) * Figures 1,5; page 6, line 8 - page 7, line 10; page 10, line 17 - page 11, line 9 * | 1-7 | H 03 F 3/45 |
| A | IBM TECHNICAL DISCLOSURE BULLETIN, vol. 16, no. 10, March 1974, pages 3140-3141, New York, US; R.C.JAEGER: "Active load for differential amplifiers" * The whole document * | 1-4 | |
| A | US-A-3 440 554 (DR. McGRAW) * Figure; column 1, line 10 - column 3, line 32 * | 1-4 | |
| A | GB-A-2 010 038 (TOKYO SHIBAURA DENKI) * Figures 5,6; column 5, lines 16-47 * | 1,2,4 | TECHNICAL FIELDS SEARCHED (Int Cl 4) |
| A | GB-A-2 057 820 (STANDARD TELEPHONES AND CABLES) * Figure 1; abstract * | 8 | H 03 F |

The present search report has been drawn up for all claims

| Place of search | Date of completion of the search | Examiner |
|---|---|---|
| THE HAGUE | 12-06-1985 | TYBERGHIEN G.M.F. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82